# EUROPEAN PATENT APPLICATION

(11) **EP 2 846 460 A1**
(43) Date of publication of application: **11.03.2015**
(21) Application number: 13306213.3
(22) Date of filing: 05.09.2013
(51) Int. Cl.: H03F 1/32, H03F 1/02, H03F 3/60, H03F 3/24

(54) **Arrangement and method for radio frequency power amplification**

(71) Applicant: ALCATEL LUCENT, 92100 Boulogne-Billancourt (FR)
(72) Inventor: Rixain, Michel, 91620 NOZAY (FR)
(74) Representative: Lück, Stephan

(57) **Abstract**

The invention refers to a radio frequency power amplifier arrangement (11) for amplifying a signal (sl). In order to provide a power amplifier arrangement (11) and a method for amplifying signal (sl) that add at most little disturbances (e) to the signal (s1) and that operate efficiently, it is proposed that the arrangement (11) comprise a digital predistorter (13) arranged for driving a power amplifier (19) of said arrangement (11) and a power supply unit (33) having an envelope tracking modulator (35) arranged for adapting at least one supply voltage of the power amplifier (19) to an envelope of the signal (sl), wherein the arrangement (11) further comprises analog compensation circuitry (41) for compensation of spurious errors (e) introduced to the signal (s1) as a result of said adapting.

## Description

### Field of the invention

The present invention refers to a radio frequency power amplifier arrangement, a network element comprising such an arrangement and a method for processing a radio frequency signal.

### Background

In today's mobile radio systems, the amplitude of radio frequency signals to be transmitted over an air interface of the radio system heavily varies. The variations of the amplitude of the radio frequency signals is due to modulation schemes applied in these radio systems.

In order keep the energy consumption and heat dissipation of power amplifier arrangements used in such radio systems low, envelope tracking may be applied. An envelope tracking capable power amplifier arrangement comprises power supply circuitry having an envelope tracking modulator for adapting a supply voltage of a power amplifier to the momentary amplitude (i.e. the envelope) of the radio frequency signal. Envelope tracking allows to efficiently amplify radio frequency signals having a heavily varying amplitude.

Typically, the power amplifier, being designed for high efficiency, is not perfectly linear and therefore causes distortions to the radio frequency signal. It is known to include a digital predistorter e.g. in the baseband signal path of the amplifier arrangement in order to compensate the nonlinearities of the power amplifier.

A digital predistorter is suitable for correcting deterministic errors caused by nonlinearities of the power amplifier that can be measured using adaptive filtering approaches. However, nondeterministic disturbances like spurious errors coupled into the radio frequency signal by the envelope tracking modulator cannot be corrected by envelope tracking. As a consequence, current power amplifier arrangements either distort the radio signal to an unacceptable high extent or they are not efficient enough for many applications related to today's radio systems like the Long Term Evolution (LTE) system or the Universal Mobile Telecommunications System (UMTS).

### Summary

The object of the present invention is to provide a power amplifier arrangement and a method for amplifying a signal that add at most little disturbances to signal and that operate efficiently.

According to a preferred embodiment of the present invention, a power amplifier arrangement for amplifying a signal is provided, the arrangement comprising a digital predistorter arranged for driving a power amplifier of said arrangement and a power supply unit having an envelope tracking modulator arranged for adapting at least one supply voltage of the power amplifier to an envelope of the signal, wherein the arrangement further comprises analog compensation circuitry for compensation of spurious errors introduced to the signal as a result of said adapting.

In other words, digital predistortion and the analog compensation are combined with each other. The digital predistortion compensates the nonlinearities of the amplifier and the analog compensation circuitry eliminates at least essentially the disturbances caused by the spurious errors. Thus, the amplifier arrangement introduces little distortions to the signals even if the power amplifier is designed for high efficiency with limited linearity and envelope tracking is applied.

The signal may be any signal that characterizes a radio frequency signal to be generated by the amplifier arrangement. For example, the signal may be a baseband signal, preferably a digital baseband signal. Accordingly, the amplifier arrangement may comprise a digital-to-analog converter and an up-converter adapted to convert the digital baseband signal into the analog radio frequency signal.

In an embodiment, the analog compensation circuitry comprises at least one reference amplifier stage having at least essentially the same transmission characteristics as a main amplifier stage, the reference amplifier stage being arranged for generating a compensation signal to be coupled into a signal path of the power amplifier. At least when the digital predistorter has reached an operating state where it has estimated the non-linear transmission characteristics of the power amplifier sufficiently accurately, the compensation signal comprises mainly spectral components of the radio signal that are due to spurious errors caused by envelope tracking. By coupling the compensation signal into the signal path, e.g. at an input of an amplifier stage of the power amplifier, the spurious errors are removed from the radio signal.

When applying envelope tracking, a main amplifier stage of the power amplifier is subject to envelope tracking, that is a supply voltage of the main amplifier stage is a modulated supply voltage generated by the envelope tracking modulator from a momentary amplitude (i.e. envelope) of the signal. In a preferred embodiment, not only the main amplifier stage but also the reference amplifier stage is subject to envelope tracking. Applying envelope tracking also to the reference amplifier stage allows generating the compensation signal more accurately. According to this embodiment, the envelope tracking modulator has an output for outputting at least one further supply voltage of the reference amplifier stage, said further supply voltage being adapted to the envelope of the signal.

In embodiment, according to which the power amplifier comprises multiple amplifier stages, it is preferred that a supply voltage for at least one amplifier stage is aligned in phase with the envelope of the radio signal present at this amplifier state. Accordingly, the envelope tracking modulator may be adapted to generate multiple different modulated supply voltages, each of them being in phases with the envelope of the signal present at the respective amplifier stage.

In an embodiment, the envelope tracking modulator has multiple outputs for outputting different supply voltages dedicated to individual amplifier stages of the power amplifier, the supply voltages outputted by said multiple outputs being delayed with respect to each other according to a position of the respective amplifier stages within a signal path of the power amplifier. In a preferred embodiment, all amplifier stages of the power amplifier are powered with such a dedicated supply voltage that is delayed such that is in phase with the envelope of the signal present at the respective amplifier stage.

In one embodiment, the main amplifier stage is arranged in series with the compensation circuitry within a signal processing path of the power amplifier. For example, the main amplifier stage is arranged after the compensation circuitry within a signal processing path of the power amplifier.

In another embodiment, the power amplifier arrangement comprises at least one main branch including the main amplifier stage and a compensation branch including the reference amplifier, the main branch and the compensation branch being connected in parallel, preferably by means of high frequency couplers.

In an embodiment, more than one main branch may be provided. For example the power amplifier may comprise two man branches and one compensation branch. The power amplifier may, in an embodiment, include a three-way splitter for connecting the two main branches and the compensation branch to a common input of the power amplifier. At least one main branch may comprise a coupler for coupling in the compensation signal generated by the compensation branch.

In an embodiment, the power amplifier arrangement is adapted for generating a transmit signal from a multi carrier input signal, preferably an OFDM signal.

Although the power amplifier arrangement can be applied in combination with any type of radio system, it is preferred that the radio frequency power amplifier arrangement be adapted for generating a transmit signal according to the Long Term Evolution, LTE, specifications. The amplitude of a LTE signal has a comparatively large dynamic range (i.e. variation of amplitude) and technical specifications of LTE are quite strict as regards the spectrum of the radio frequency signal emitted e.g. by a base station. The power amplifier arrangement described herein can efficiently cope with signals having a large dynamic range without introducing distortions that lead to unwanted spectral components of the signal that do not comply with the technical specifications of LTE. Therefore, the power amplifier arrangement is particularly well-suited for radio frequency transmitters used in LTE.

According to another embodiment of the present invention, a network element for a mobile communication system is provided, the network element comprising a radio frequency power amplifier arrangement according to the present invention, embodiments thereof are herein described.

In a preferred embodiment, the network element is a remote radio head or a base station for a radio access network of a mobile communication system.

According to yet another embodiment of the present invention, a method for amplifying a signal is provided, the method comprising generating a predistorted signal from the signal by means of a digital predistorting, driving a power amplifier by the predistorted signal and powering the power amplifier by adapting at least one supply voltage for the power amplifier to an envelope of the a signal, wherein the method further comprises compensating spurious errors introduced to the signal as a result of said adapting by analog compensation circuitry of the power amplifier.

In an embodiment, the method is executed by a radio frequency power amplifier arrangement described herein. The method may therefore include any combination of features of the power amplifier arrangement described herein.

### Brief description of the figures

Exemplary embodiments and further advantages of the present invention are shown in the Figures and described in detail hereinafter.
- Figure 1: shows a block diagram of a radio frequency power amplifier arrangement;
- Figure 2: shows a diagram illustrating spurious errors introduced to a radio frequency signal to be processed by the power amplifier arrangement which error is caused by an envelope tracking modulator of the amplifier arrangement;
- Figure 3: shows a detail of the amplifier arrangement according to a first embodiment;
- Figure 4: shows a detail of the amplifier arrangement according to a second embodiment;
- Figure 5: illustrates iterations of a digital predistorter of the power amplifier arrangement;
- Figure 6: shows a detail of the power amplifier arrangement according to a third embodiment; and
- Figure 7: shows a detail of the power amplifier arrangement according to a fourth embodiment.

### Description of the embodiments

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

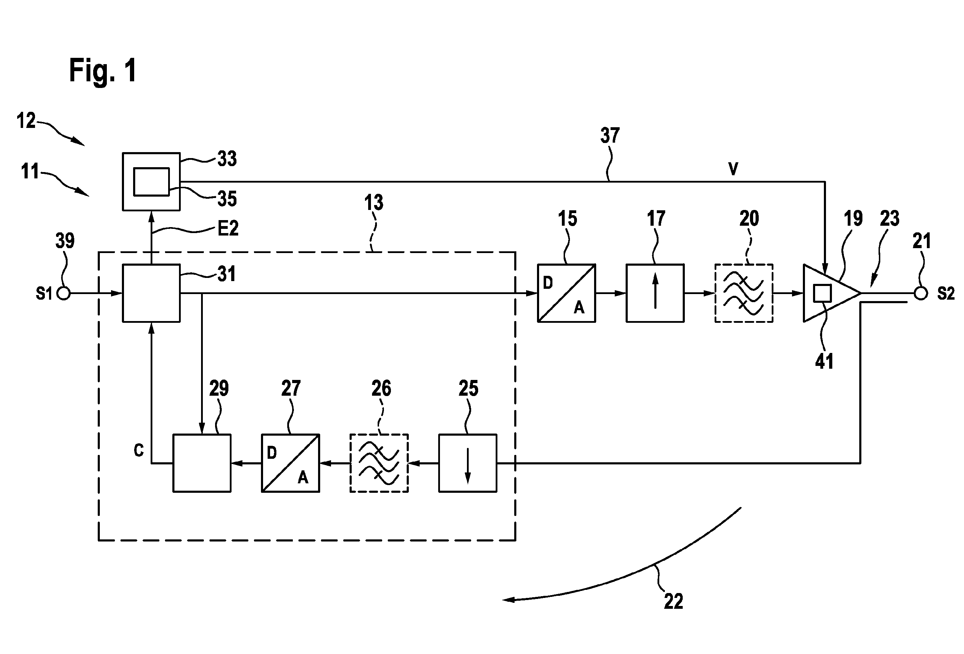

The block diagram of Figure 1 gives an overview on a radio frequency power amplifier arrangement 11. The amplifier arrangement 11 may be used e. g. in radio transmission systems for a wireless radio access network, in particular for a cellular radio access network like a Long-Term Evolution (LTE) access network or a Universal Mobile Telecommunication System (UMTS) network. Consequently, the amplifier arrangement 11 may be part of a network element such as a base station 12 or a remote radio head.

The amplifier arrangement 11 comprises a digital predistorter 13 having an input for inputting a baseband signal s1. An output of the digital predistorter 13 is connected to a digital-to-analogue converter 15 that is followed within a signal path of the amplifier arrangement 11 by an up-converter 17. An output of the up-converter 17 is connected to an input of a power amplifier 19 of the amplifier arrangement 11. An optional first filter, e.g. a first band pass filter 20, may be arranged between the up-converter 17 and the power amplifier 19. An output of the power amplifier 19 corresponds to an output 21 of the amplifier arrangement 11 for outputting radio frequency signal s2. The output 21 may be connected directly or indirectly to an antenna (not shown) of a network element (e.g. base station or remote radio head) that includes the amplifier arrangement 11.

Moreover, the amplifier arrangement 11 has a feedback path (arrow 22). The feedback path 22 begins at a feedback coupler 23 arranged at the output of the power amplifier 19 goes through a down converter 25 of the digital predistorter 13, an analog-to-digital converter 27 of the digital predistorter 13 and ends at training circuitry 29 of the digital predistorter 13. An optional second filter, e.g. a second band pass filter 26 may be arranged between the down-converter 25 and the analog-to-digital converter 27. The training circuitry 29 is not only connected to an output of the analogue-to-digital converter 27 but also to an output of the pre-distorting circuitry 31 of the digital predistorter 13. A control output of the training circuitry 29 is connected to a control input of the pre-distorting circuitry 31.

The amplifier arrangement 11 includes a power supply unit 33 comprising an envelope tracking modulator 35. The envelope tracking modulator 35 is arranged for providing the power amplifier 19 (or, as described in more detail below, multiple amplifier stages of the power amplifier 19) with a power supply voltage, as illustrated with arrow 37. A further control output of the pre-distorting circuitry 31 is connected to a further control input of the envelope tracking modulator 35. As can be further seen in Figure 1, the predistorting circuitry 31 is located in the signal path of the amplifier arrangement between an input 39 for inputting the baseband signal s1 and the input of the digital-to-analogue converter 15. That is, the pre-distorting circuitry 31 is located in a digital baseband part of the amplifier arrangement 11.

When operating the amplifier arrangement 11, the digital baseband signal s1 is fed into the input 39 of the amplifier arrangement. The pre-distorting circuitry 31 pre-distorts the baseband signal s1 in order to pre-compensate nonlinearities of the power amplifier 19. Predistorting may include performing nonlinear transformations on the baseband signal s1. For this purpose, suitable logic circuitry such as lookup tables or the like may be applied. The digital-to-analogue converter 15 converts the baseband signal to a corresponding analogue signal with is then converted to a higher frequency by the up-converter 17 and then amplified by the power amplifier 19. The power amplifier 19 being optimized for high efficiency is not perfectly linear and therefore distorts the signal. The digital predistorter 13 is adapted to introduce additional distortions to the signal s1 in order to compensate the nonlinearities of the power amplifier 19.

In the shown embodiment, the digital predistorter is adaptive, applying an adaptation approach usually referred to as "indirect learning" which is based on adaptive filtering techniques applied in the training circuitry 29. That is, the training circuitry 29 compares the signal outputted by the pre-distorting circuitry 31 with the signal obtained via the feedback path 22 and thereby estimates transmission characteristic C of the power amplifier 19. The transmission characteristics C determined by the training circuitry 29 are forwarded to the predistorter circuitry 31 so that the pre-distorting circuitry 31 pre-compensates the nonlinearities of the power amplifier 19. According to the indirect learning approach, both the training circuitry 29 as well as the pre-distorting circuitry 31 is based on the same signal processing model. Digital pre-distortion, in particular the indirect learning approach, is well known and will therefore not be discussed in detail herein. The present invention is not limited to a certain type of digital predistorter 13 and embodiments may use different types and approaches for predistortion than indirect learning.

The adaptive digital predistorter 13 learns the transmission characteristics C of the power amplifier iteratively and recursively by comparing the signal outputted by the distorting circuitry 31 and the signal feedback via the feedback path 22 with each other. After a certain number of iterations, training circuitry 29 has determined a sufficiently good estimate of the transmission characteristics C of the power amplifier 19 so that the nonlinearities of the power amplifier 19 can be compensated sufficiently by predistorting the baseband signal s1 using the pre-distortion circuitry 31.

In order to further improve the efficiency of the power amplifier arrangement 11, the envelope tracking modulator 35 adapts a supply voltage V of the power amplifier 19 according to a momentary envelope of the baseband signal s1. In the shown embodiment, a digital signal E2 is generated e. g. by the pre-distorting circuitry 31 or by different circuitry of the power amplifier arrangement 11 that represents the momentary envelope E1 of the baseband signal s1. In another embodiment, the digital signal E2 represents the momentary envelope of the pre-distorted signal at input of amplifier 19 or the signal obtained via feedback path 22.

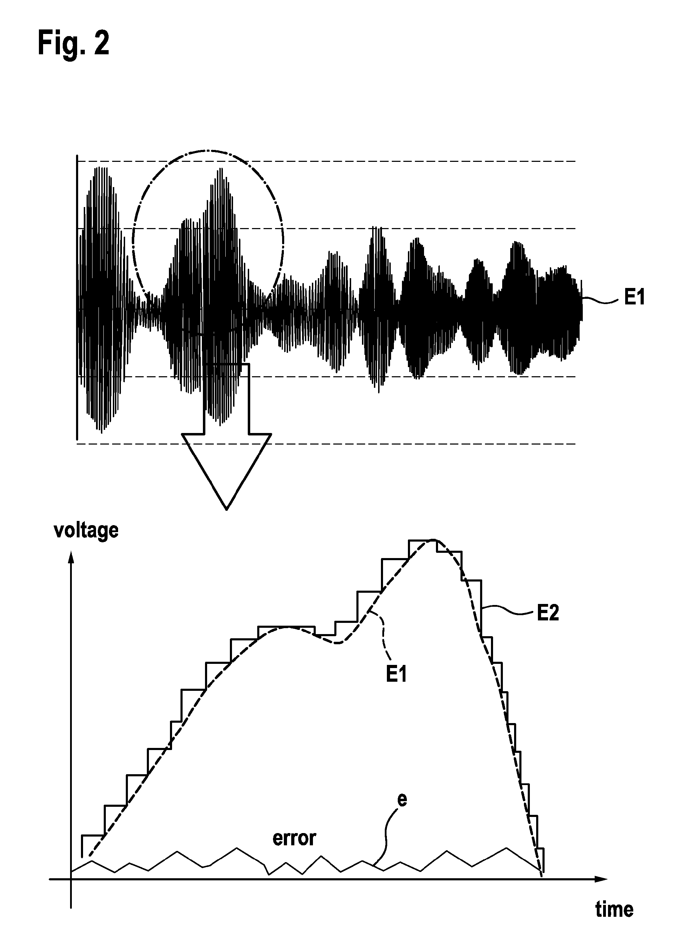

The actual envelope E1 of the baseband signal s1 and the digital representation E2 of the envelope are shown in Figure 2. The diagram at the bottom of Figure 2 shows a detail of the diagram at the top of Figure 2. Because of the limited resolution of the digital envelope signal E2, a difference between the digital envelope signal E2 and the actual envelope E1 is not always zero. The difference between the two signals E1, E2 is also referred to as error e of the digital envelope signal E2. Because the power supply voltage of the power amplifier 19 or one or more amplifier stages thereof is controlled depending on the digital envelope signal E2, the error e is coupled in the radio frequency signal outputted by the power amplifier 19. This error e is not correlated to the baseband signal s1 and therefore can be considered as spurious noise from the perspective of the pre-distorting circuitry 31.

The digital predistorter 13 being based on an iterative and recursive adaptation approach can only correct deterministic errors of the power amplifier 19, i.e. errors that depend on the digital baseband signal s1. As a consequence, the spurious error e cannot be removed by the digital predistorter 13. However, in many applications of the amplifier arrangement 11, in particular when using the amplifier arrangement in combination with LTE systems, these spurious errors e cannot be tolerated because they enlarge the spectrum of the radio frequency signal s2 outputted by the power amplifier 19 in such an extent, that the spectrum does not comply to technical specifications of LTE not anymore. In order to reduce of even eliminate the spurious error e of the radio frequency signal s2, the power amplifier according to embodiments described herein includes compensation circuitry for compensation of these spurious errors e introduced to the radio frequency signal s2 as a result of the adaptation of the supply voltage by means of envelope tracking performed by the envelope modulator 35.

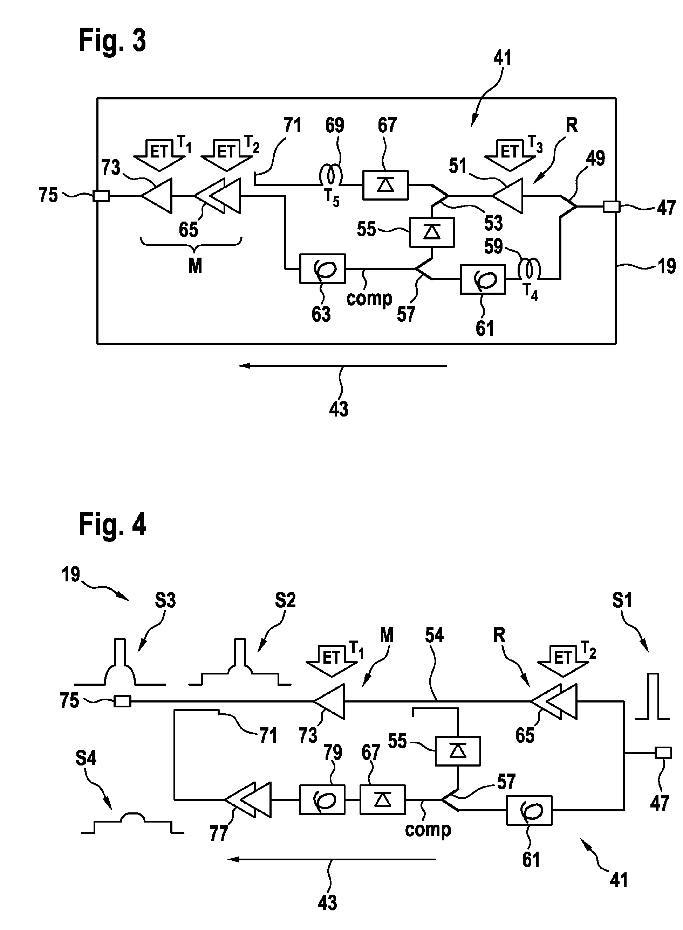

In a first exemplary embodiment shown in Figure 3, the compensation circuitry 41 is located within the signal path 43 before one or more main amplifier stages M. An input port 47 of the power amplifier 19 is connected to the first splitter 49 that splits a signal inputted via the input port 47 into two components. One component of the signal goes to the first stage 51 of the power amplifier 19, an input of which is connected to the first splitter 49. An output of the first stage 51 is connected to an input of the second splitter 53 having two outputs. The first output of the second splitter 53 is connected via a first attenuator 55 to a first input of a first combiner 57. A second output of the first splitter 49 is connected via a first delay element 59 and a first phase shifter 61 to the second input of the first combiner 57. The first delay element 59 and the first phase shifter 61 are arranged such that the two signals at the first combiner are inversely phased with respect to each other and therefore subtracted from each other.

An output of the first combiner 57 is connected via a second delay element 63 to an input of a second stage 65. The first output of the second splitter 53 is connected via a second attenuator 67 and a second delay element 69 to a coupler 71 arranged for coupling a signal going through the second attenuator and the second delay element 69 into the input of the second stage 65. A third stage 73 of the power amplifier 19 is arranged within the signal path 43 after the second stage 65. An output of the third stage 73 is connected to an output port 75 of the power amplifier 19. In this embodiment, the stages 65 and 73 constitute main amplifier stages M.

Moreover, the amplifier stages 51, 65, 73 are subject to envelope tracking, as illustrated by arrows labeled with ET. Modulated supply voltages of the stages 51, 65, 73 are delayed by respective delays τ1, τ2, τ3 so that the supply voltages are in phase with the radio frequency signal at the individual stages 51, 65, 73.

When operating the amplifier 19, the combiner 57 subtracts a radio frequency signal inputted via the input port 47 and the same radio frequency signal amplified by the first stage 51 from each other. Because enveloped tracking modulation is applied on the first stage 51, a spectrum S2 of a signal outputted by the first stage 51 includes not only the wanted signal but also portions caused by nonlinearities and the spurious errors e caused by the first stage 51. The combiner 57 subtracts the signal amplified by stage 51 from the delayed signal inputted via the input port 47 so that the signal at the output of the first combiner 57 includes the undesired parts of the signal caused by nonlinearities and spurious errors e only. The signal at the output of the first combiner 57 is herein also referred to as compensation signal *comp.* The stage 51 is used to determine the spurious errors e introduced by an amplifier stage of the amplifier 19. Therefore, the amplifier stage 51 is herein also referred to as reference amplifier stage R of the compensation circuitry 41. Preferably, the reference amplifier stage R has the same or at least similar transmission characteristics as the other stages of the amplifier, so that the compensation signal *comp* can eliminate the spurious errors e caused by the other stages at least partially. Besides the reference stage R, the compensation circuitry 41 may include additional components. The number and type of these additional components depend on the concrete embodiment. In the embodiment shown in Figure 3, the compensation circuitry 41 includes the first delay element 59, the first phase shifter 61, the first combiner 57, the first attenuator 55, the second splitter 53, the second delay element 63 and the coupler 71. In the shown embodiments, not only the at least one main stage of the amplifier but also the reference stage R is subject to envelope tracking modulation. Thus, the compensation circuitry determines the compensation signal *comp* comprising the spurious errors e particularly precisely.

By delaying the compensation signal *comp* by means of the phase shifting element 63 and combining it with the amplified signal by means of the first coupler 71, at least the spurious errors e are reduced or increased and is aligned in opposite phase to the spurious errors produced by 73 and 65 in order to cancel them . By appropriately tuning various parts of the power amplifier, in particular of the attenuators, 67 and of the phase shifter 63 the spurious errors e introduced by the stage 65, 73 are also reduced or eliminated. In the ideal case, the spectrum of the signal at the output port 75 corresponds to the desired radio frequency only (spectrum S1).

A second embodiment of the power amplifier 19 is shown in Figure 4. Corresponding elements have the same reference signs as the elements of the power amplifier shown in Figure 3. In this embodiment, the stage 65 is connected directly to the input port 47. The splitter 53 is replaced by a coupler 54, which is arranged between the two stages 65, 73. Consequently, the stage 65 constitutes the reference stage R. Moreover, the stage 65 functions as a driver for driving the stage 73. The stages 73 and 65 stages are the main stages M of the amplifier 19. The power amplifier 19 has a further stage 77. The output of the further stage 77 is connected to the coupler 71. The second attenuators 67 and a further phase shifter 79 are arranged between the output of the first combiner 57 and the further stage 77. The compensation circuitry 41 includes the elements 61, 65, 55, 67, 79, 77, 71.

The amplifier arrangement 11 according to the embodiments described herein has basically two means for correcting non-ideal behavior of a power amplifier 19. First, the digital predistorter 19 located in the digital baseband part of the amplifier arrangement 11 compensates at least partially nonlinearities of the amplifier. Second, the spurious error e, which cannot be eliminated by digital predistortion, is reduced or completely eliminated by the analogue compensation circuitry 41 which is part of the power amplifier 19 and therefore is located in radio frequency part of the amplifier arrangement, i.e. in the signal path after the up-converter 17 of the amplifier arrangement.

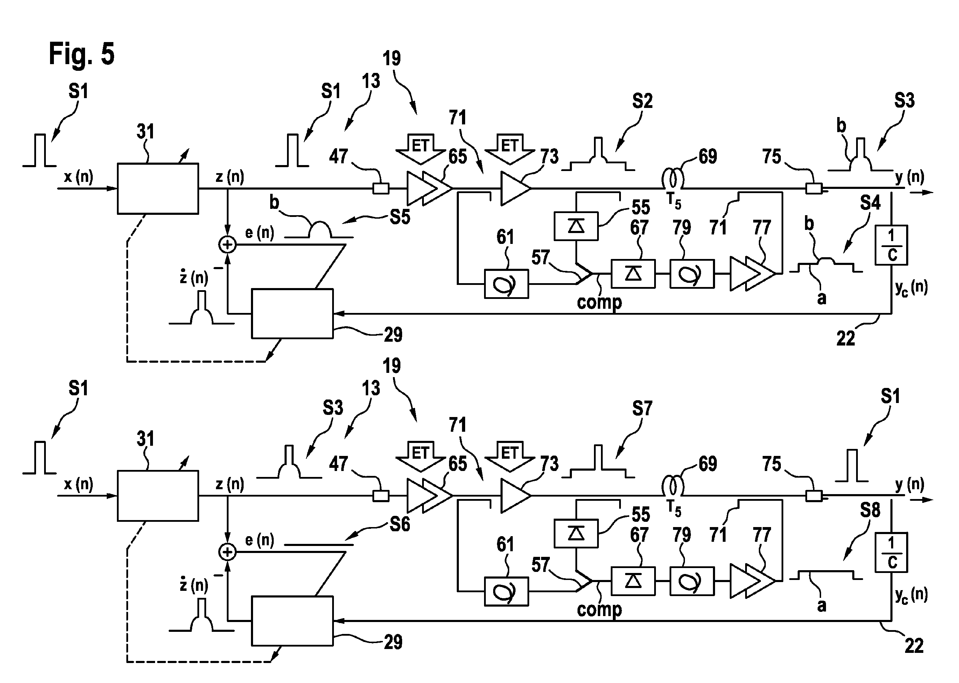

Figure 5 illustrates how these two means for compensating the non-ideal behavior of the power amplifier 19 work together. In the diagrams of Figure 5, the spectrum at different parts of the amplifier arrangement 11 is depicted in a schematic way for illustrative purposes. The upper diagram of Figure 5 shows the spectrum of these various signals within the amplifier arrangement 11 at a time instance when the digital pre-distortion has not yet correctly estimated the transmission characteristics C of the power amplifier. This could correspond to an operating state of the amplifier arrangement just after power up or during a first iteration of the iterative adaptation process performed by the digital predistorter 13. It is assumed, that the modulated baseband signal s1 has an ideal rectangular-shaped spectrum S 1. Because the training circuitry has not yet estimated the transmission characteristics C of the power amplifier, the training circuitry 29 simply uses ideal, i.e. linear, transmission characteristics as a starting point of the iterative adaptation process. As a consequence, the pre-distorting circuitry 31 leaves the digital baseband signal s1 unmodified and the spectrum of the signal generated by the predistorting circuitry 31 corresponds to the spectrum S1 of the digital baseband signal.

Because the two stages 65, 73 show non-ideal behavior, the signal output at stage 73 comprises portions caused by the non-linearity of the stages 65, 73 as well as spectral portions caused by the spurious errors e introduced to the radio frequency signal as a result of the envelope tracking (spectrum S2). The compensation circuitry of the power amplifier 19 generates a compensation signal *comp* to be combined with the signal generated by a stage 73. The compensation signal *comp* comprises undesired parts of the radio frequency signal (spectrum S4). The compensation signal *comp* therefore includes the portion *a* of the radio frequency signal caused by the spurious errors e and a portion *b* caused by the nonlinearities. However, the compensation circuitry 41 of the power amplifier 19 is not well-suited for compensation of nonlinearities. Therefore, the compensated signal resulting from the superposition of the distorted radio frequency signal S2 with the compensation signal comp still includes nonlinearities. However, the disturbances caused by the spurious errors e have at least almost completely been removed from the radio frequency signal (spectrum S3).

The signal comprising the spectrum S3 is fed back via the feedback path 22 to the digital predistorter 13 and the digital predistorter 13 performs multiple iterations in order to determine the actual transmission characteristics C of the power amplifier 19. As a consequence, the digital predistorter 13 eventually, after a certain number of iterations, has acquired the actual transmission characteristics C of the power amplifier 19 and the pre-distorting circuitry 31 pre-distorts the baseband signal according to the transmission characteristics C of the power amplifier 19. As shown in the diagram at the bottom of Figure 5, the signal generated by the pre-distorting circuitry 31 is modified with respect to the original baseband signal when the digital predistorter 13 has estimated the transmission characteristics C of the power amplifier after some iterations. Consequently, signals generated by the pre-distorting circuitry 31 have the spectrum S3 comprising the nonlinearities.

In Figure 5 a digital, time discrete error signal e(n) is shown which is calculated form a digital signal z(n) at the output of the predistorting circuitry 31 and a scaled version y_{c}(n) of the down-converted and digitalized radio frequency signal y(n). For the sake of simplicity, the down-converter 25, the analog-to-digital converter 27, the down-converter 25 and the analog-to-digital converter 27 are not shown in Figure 5. When the digital predistorter 13 has not yet reached a state where the transmission characteristics C have been determined, the error signal e(n) includes spectral portions b related to the nonlinearities of the power amplifier 19 (see spectrum S5). After some iteration, when the transmission characteristics C have been determined, the error signal e(n) is almost zero (see spectrum S6).

Digital predistortion has the effect that the signal output by the stage 73 has at most little disturbances caused by nonlinearities resulting in a spectrum S7 at the output of stage 73. In other words, the signal at the output of stage 73 is mainly disturbed by the spurious errors e. The compensation circuitry generates a compensation signal *comp* comprising these disturbances related to spurious errors e. Because the nonlinearities have at least almost been eliminated completely by digital predistortion, the compensation signal *comp* does not include any portions *b* related to nonlinearities anymore. Therefore, the compensation signal has a spectrum S8 comprising portions *a* due to the spurious errors e only. When applying the compensation signal *comp* to the signal outputted by the stage 73 by means of coupler 71, the resulting radio frequency signal at the output of the power amplifier 19 has at most very little disturbances due to the spurious errors e. As a consequence, the spectrum of the radio frequency signal corresponds at least essentially to the spectrum S1 of the corresponding digital baseband signal. The radio frequency signal complies therefore with the technical specification of the respective radio system such as LTE.

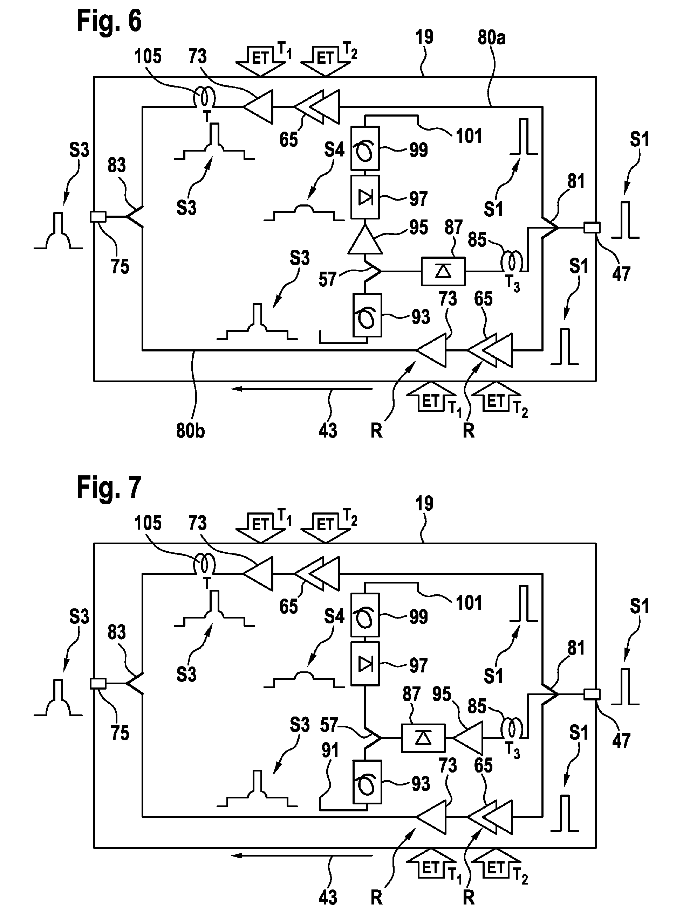

In another embodiment of the power amplifier 19 shown in Figure 6, two amplifier branches 80a, 80b, each of them comprising two stages 65, 73 arranged in series, are connected in parallel. The branches 80a, 80b begin at a three-way splitter 81 connected to the input port of the power amplifier 19 and end at a combiner 83 connected to the output port 75 of the power amplifier 19.

Two outputs of the splitter 81 are connected to the respective inputs of the stage 65 belonging to the two amplifier branches 80a, 80b. A third output of the splitter 81 is connected via a further delay element 85 and a further attenuator 87 to the first combiner 57. An output of stage 73 of the amplifier branch 80b shown at the bottom of Figure 6 is connected via a coupler 91 and a phase shifter 93 to the first combiner 57. The output of the first combiner 57 is connected to a further amplifier stage 95, followed by a further attenuator 97 and a further phase shifter 99. A further coupler 101 couples the compensation signal *comp,* which is present at an output of the further phase shifter 99, into a signal at the input of stage 65 of the amplifier branch 80a at the top of Figure 6 so that the spurious errors e not only of the amplifier path 80a at the top of Figure 6 also the spurious errors caused by the amplifier branch 80b at the bottom of Figure 6 are compensated at least partially. Schematic diagrams of the spectrum of the signals at certain parts of the power amplifier 19 are also depicted in Figure 6.

Figure 7 shows a variant of the embodiment shown in Figure 6. This embodiment differs from the embodiment of Figure 6 in that the amplifier stage 95 is located between the delay element 85 and the further attenuator 87 and not between the first combiner 57 and the further phase shifter 99. In the embodiments shown in Figure 6 and figure 7, a further delay element 105 may be inserted between the stage 73 and the combiner 83. In the embodiments shown in Figures 6 and 7, the amplifier stages 65, 73 at the bottom branch 80b constitute reference stages R. The compensation circuitry 41 comprises the elements 85, 87, 57, 93, 91, 65, 73, 95, 97, 99 and 101.

To sum up, the embodiments of the amplifier arrangement 11 described herein comprise two measures for compensating non-ideal behavior of the radio frequency power amplifier 19 of the amplifier arrangement 11. The digital predistorter located in a digital baseband part of the amplifier arrangement 11 compensates nonlinearities at least essentially, whereas the compensation circuitry 41 of the power amplifier 19 being part of a radio frequency part of the amplifier arrangement 11, compensates disturbances of the radio frequency signal cause by spurious errors introduced by the envelope tracking modulator 35. The combination of these two compensation measures 13, 41 allows to implement high-efficiency power amplifiers that are adapted to generate radio frequency signals whose spectrums comply with technical specification of current third generation or fourth radio systems like UMTS or LTE.

## Claims

1. Radio frequency power amplifier arrangement (11) for amplifying a signal (s1), the arrangement (11) comprising a digital predistorter (13) arranged for driving a power amplifier (19) of said arrangement (11) and a power supply unit (33) having an envelope tracking modulator (35) arranged for adapting at least one supply voltage (V) of the power amplifier (19) to an envelope (E1) of the signal (s1), wherein the arrangement (11) further comprises analog compensation circuitry (41) for compensation of spurious errors (e) introduced to the signal (s1) by said adapting.

2. Arrangement (11) according to claim 1, wherein the analog compensation circuitry (41) comprises at least one reference amplifier stage (R) having at least essentially the same transmission characteristics as a main amplifier stage (M), the reference amplifier stage (R) being arranged for generating a compensation signal (comp) to be coupled into a signal path (43) of the power amplifier (19).

3. Arrangement (11) according to claim 1 or 2, wherein the envelope tracking modulator (35) has an output for outputting at least one further supply voltage to the reference amplifier stage (R), said further supply voltage being adapted to the envelope (E1) of the signal (s1).

4. Arrangement (11) according to claim 3, wherein the envelope tracking modulator (35) has multiple outputs for outputting different supply voltages (V) dedicated to individual amplifier stages (51, 65, 73, 95) of the power amplifier (19), the supply (V) voltages outputted by said multiple outputs being delayed with respect to each other according to a position of the respective amplifier stages (51, 65, 73, 95) within a signal path (43) of the power amplifier (19).

5. Arrangement (11) according to one of the precedent claims, wherein the main amplifier stage is arranged in series with the compensation circuitry (41) within a signal processing path of the power amplifier (19).

6. Arrangement (11) according to one of claims 1 to 4, wherein the power amplifier arrangement (11) comprises at least one main branch including the at least one main amplifier stage (65, 73) and a compensation branch including the reference amplifier stage (R), the main branch and the compensation branch being connected in parallel, preferably by means of high frequency couplers (81, 83).

7. Arrangement (11) according to one of the precedent claims, wherein the radio frequency power amplifier arrangement (11) is adapted for generating a transmit signal (s2) from a multi carrier input signal (s1), preferably an OFDM signal.

8. Arrangement (11) according to one of the precedent claims, wherein the radio frequency power amplifier arrangement (11) is adapted for generating a transmit signal (s2) according to the Long Term Evolution, LTE, specifications.

9. Network element (12) for a mobile communication system, the network element comprising a radio frequency power amplifier arrangement (11) according to one of the precedent claims.

10. Network element (12) according to claim 9, wherein the network element is a remote radio head or a base station (12).

11. Method for amplifying a signal (s1), the method comprising generating a predistorted signal from the signal (s1) by means of a digital predistorter (13), driving a power amplifier (19) with the predistorted signal and powering the power amplifier (19) by adapting at least one supply voltage for the power amplifier (19) to an envelope (E1) of the signal (s1), wherein the method further comprises compensating of spurious errors (e) introduced to the signal (s1) by said adapting.

12. Method according to claim 11, wherein the compensating of the spurious errors (e) is performed by analog compensation circuitry (41) of the power amplifier (19).

13. Method according to claim 11 or 12, wherein the method is executed by a radio frequency power amplifier arrangement (11) according to one of claims 1 to 8.

## Amended claims

### Amended claims in accordance with Rule 137(2) EPC.

1. Radio frequency power amplifier arrangement (11) for amplifying a signal (s1), the arrangement (11) comprising a power supply unit (33) having an envelope tracking modulator (35) arranged for adapting at least one supply voltage (V) of the power amplifier (19) to an envelope (E1) of the signal (s1) and analog compensation circuitry (41), **characterized in that** the arrangement (11) comprises a digital predistorter (13) arranged for driving a power amplifier (19) of said arrangement (11) and **in that** the compensation circuitry (41) comprises a reference amplifier stage (R) arranged for generating a compensation signal (comp) for compensation of spurious errors (e) introduced to the signal (s1) by said adapting.

2. Arrangement (11) according to claim 1, wherein the analog compensation circuitry (41) comprises at least one reference amplifier stage (R) having at least essentially the same transmission characteristics as a main amplifier stage (M).

3. Arrangement (11) according to claim 1 or 2, wherein the envelope tracking modulator (35) has an output for outputting at least one further supply voltage to the reference amplifier stage (R), said further supply voltage being adapted to the envelope (E1) of the signal (s1).

4. Arrangement (11) according to claim 3, wherein the envelope tracking modulator (35) has multiple outputs for outputting different supply voltages (V) dedicated to individual amplifier stages (51, 65, 73, 95) of the power amplifier (19), the supply (V) voltages outputted by said multiple outputs being delayed with respect to each other according to a position of the respective amplifier stages (51, 65, 73, 95) within a signal path (43) of the power amplifier (19).

5. Arrangement (11) according to one of claims 2 to 4, wherein the main amplifier stage (M) is arranged in series with the compensation circuitry (41) within a signal processing path of the power amplifier (19).

6. Arrangement (11) according to one of claims 2 to 4, wherein the power amplifier arrangement (11) comprises at least one main branch including the at least one main amplifier stage (M; 65, 73) and a compensation branch including the reference amplifier stage (R), the main branch and the compensation branch being connected in parallel, preferably by means of high frequency couplers (81, 83).

7. Arrangement (11) according to one of the precedent claims, wherein the radio frequency power amplifier arrangement (11) is adapted for generating a transmit signal (s2) from a multi carrier input signal (s1).

8. Arrangement (11) according to one of the precedent claims, wherein the radio frequency power amplifier arrangement (11) is adapted for generating a transmit signal (s2) according to the Long Term Evolution, LTE, specifications.

9. Network element (12) for a mobile communication system, the network element comprising a radio frequency power amplifier arrangement (11) according to one of the precedent claims.

10. Network element (12) according to claim 9, wherein the network element is a remote radio head or a base station (12).

11. Method for amplifying a signal (s1), the method comprising generating a predistorted signal from the signal (s1); driving a power amplifier (19) with the predistorted signal; powering the power amplifier (19) by adapting at least one supply voltage for the power amplifier (19) to an envelope (E1) of the signal (s1); and compensating errors by means of analog compensation circuitry (41); **characterized in that** the predistorted signal is generated by means of a digital predestorter (13) and **in that** said compensating comprises generating, by means of a reference amplifier stage (R) of the analog compensation circuitry (41), a compensation signal (comp) for compensating spurious errors (e) introduced to the signal (s1) by said adapting.

12. Method according to claim 12, wherein the method is executed by a radio frequency power amplifier arrangement (11) according to one of claims 1 to 8.
